Europäisches Patentamt

(19) European Patent Office

Office européen des brevets

(11) Numéro de publication: **0 274 970 B1**

(12) **FASCICULE DE BREVET EUROPEEN**

(45) Date de publication de fascicule du brevet:
30.10.91

(51) Int. Cl.5: **D02G 3/02**, D02G 3/44,
B01D 39/08, H05K 9/00

(21) Numéro de dépôt: 87420344.1

(22) Date de dépôt: 16.12.87

(54) **Filé de fibres de carbone.**

(30) Priorité: 18.12.86 FR 8618384

(43) Date de publication de la demande:
20.07.88 Bulletin 88/29

(45) Mention de la délivrance du brevet:
30.10.91 Bulletin 91/44

(84) Etats contractants désignés:
AT BE CH DE ES FR GB GR IT LI LU NL SE

(56) Documents cités:
FR-A- 2 322 223
US-A- 4 444 574

B. VON FALKAI: "SYNTHEHESEFASERN",
1981, pages 247-268, Verlag Chemie, Weinheim, DE

(73) Titulaire: **"S.A. SCHAPPE" Société Anonyme
dite:**

**F-01230 Saint Rambert en Bugey(FR)**

(72) Inventeur: **Guevel, Jean
La Perrinche
F-01440 Viriat(FR)**
Inventeur: **Francois, Marc
3 route de Champagne
F-69130 Ecully(FR)**
Inventeur: **Bontemps, Guy
76 rue Centrale
F-01970 Tenay(FR)**

(74) Mandataire: **Maureau, Philippe et al
Cabinet Germain & Maureau Le Britannia -
Tour C 20, bld Eugène Déruelle Boîte Postale 3011
F-69392 Lyon Cédex 03(FR)**

## Description

La présente invention concerne un procédé de fabrication de filé de fibres de carbone et filé de fibres de carbone obtenu par ce procédé.

Les fibres de carbone sont bien connues par leurs applications à usage technique ; elles trouvent, en particulier, de nombreux emplois dans les matériaux composites.

Actuellement sur le marché, il existe deux types de carbone, commercialisés en multifilaments continus dans les titres suivants :

| Nombre de filaments | Numéro métrique |
|---|---|
| 3 K (K = $10^3$) | 5,12 |
| 6 K | 2,56 |
| 12 K | 1,18 |
| 40 K | 0,38 |

Les deux types de carbone se différencient par leurs propriétés physiques :

| | Haute résistance (HR) | Haut Module (HM) |
|---|---|---|
| Teneur en carbone | 97 % | 99,5 % |
| Résistance | 3,3 GPa | 2,2 GPa |
| Module de Young | 230 GPa | 335 GPa |
| Allongement de rupture | 1,55 % | 0,75 % |
| Masse volumique | 1,78 | 1,86 |
| Diamètre des fibres | 6,8 microns | 6,6 microns. |

La variété des titrages proposés par les producteurs est donc très limitée.

Par ailleurs, les filaments se présentent sous forme de rubans plats très lisses qui posent les problèmes au niveau de la stabilité du réseau, en particulier dans le cas où le produit est tissé.

Il n'existe pas, pour le moment, sur le marché des filés de fibres de carbone permettant de répondre aux besoins de différents secteurs, et notamment de disposer d'une large gamme de titres fins qui n'existent pas en multifilaments.

En effet, les seuls fibres de carbone coupées que l'on rencontre actuellement sont constituées de fibres de très petites dimensions, obtenues par coupe mécanique au couteau et qui ne sont, en aucun cas, susceptibles d'être réunies pour constituer des filés de fibres.

Le document FR-A-2 322 223 décrit une opération de craquage effectuée sur une mèche de filaments continus de polyacrylonitrile oxydé. Il ne s'agit que de fibres partiellement oxydées, la carbonisation qui les transforme totalement en fibres de carbone étant effectuée ultérieurement.

Le document US-A-4 444 574 décrit la réalisation d'un filtre à partir de fibres de polyacrylonitrile oxydé de façon contrôlée avec une teneur en carbone d'environ 61 %.

Le but de l'invention est de fournir un procédé de fabrication de filés de fibres de carbone, possèdant une teneur élevée en carbone sous forme graphitique et dont les fibres soient suffisamment longues.

A cet effet, le procédé qu'elle concerne consiste à transformer, selon une technique de craquage par étirage et rupture contrôlée des câbles de multifilaments de carbone, dont la teneur en carbone est supérieure à 95 %, dont le titre est compris entre 0,5 et 1 dtex, dont la résistance est comprise entre 2,2 et 3,3 GPa, dont le module d'Young est compris entre 230 et 335 GPa, et dont l'allongement à la rupture est compris entre 0,75 et 1,55 %, pour obtenir des fibres longues dont la longueur moyenne se situe entre 100 et 120 mm, puis à transformer ces fibres sur un matériel de filature classique pour fibres longues en une gamme de filés dont les titres sont compris entre Nm 1 et Nm 100.

L'invention concerne également des filés de fibres de carbone obtenus par ce procédé.

On effectue ensuite les opérations complémentaires de finition telles que le retordage à 2,3 ou x bouts.

Les fils simples peuvent être utilisés dans l'état où ils sortent de la filature après bobinage.

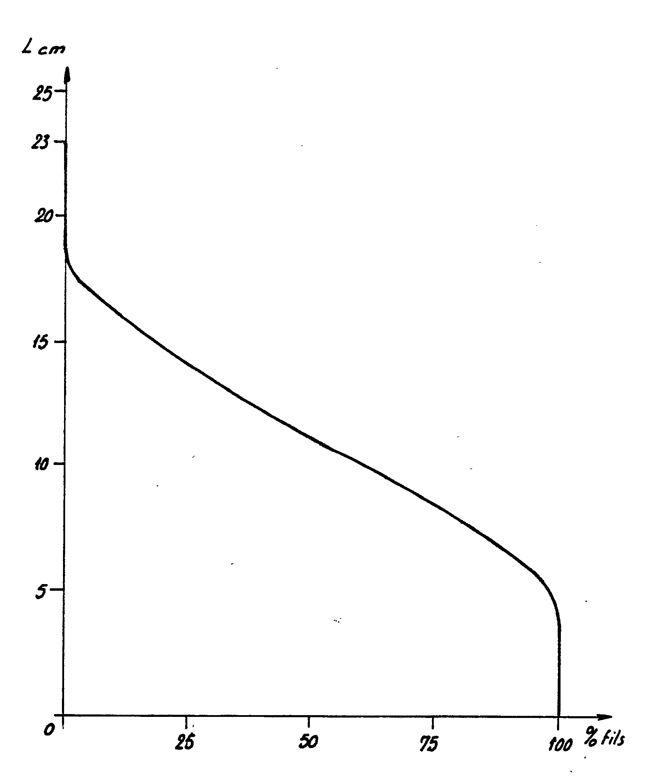

La figure unique du dessin schématique annexé est un diagramme de longueurs des fibres selon l'invention selon une répartition croissante des longueurs. On a porté en ordonnées les longueurs en centimètres et en abscisse la population des fibres exprimée en pourcentage du nombre de fils de cette population.

On voit que la moyenne se situe autour de 110 mm.

Par rapport aux filaments de départ, les fils obtenus conservent 70 % environ des propriétés mécaniques. Par ailleurs, à titre égal, le volume apparent des fils est supérieur à celui des filaments continus, et de section circulaire.

Les nouveaux filés de fibres de carbone, selon l'invention, trouvent de très nombreuses applications dans différents secteurs, tels que les tissus pré-imprégnés pour composites, les tissus pour filtration sèche et humide et les tissus pour confection de cages de Faraday ( résistance électrique : 1 microhm.m).

Ils sont également très adaptés à la confection de tissus destinés à la carbonisation pour pièce en carbone/carbone.

En effet, la perte de masse de 3 % opposée au 35 % obtenu en partant de fils pré-oxydés de 65 % de carbone permet une économie de temps, de mise en oeuvre et de matière (freins, embrayages, pièces de friction, tuyères de moteurs à combustion interne, pièces diverses devant résister à des températures élevées).

Enfin, ils peuvent être employés pour réaliser des garnitures d'étanchéité de haute performance sur les circuits vapeur ou eau surchauffée (450°C).

Les filés de fibres de carbone, selon l'invention, présentent par rapport aux filaments continus les avantages suivants :
- meilleure adéquation des titres de fil pour les emplois requis, en particulier, existence d'une large gamme de titres fins qui n'existent pas en multifilaments ;
- volume plus important à titre identique,
- prix inférieur aux filaments continus en titres fins.

**Revendications**

1. Procédé de fabrication de filé de fibres de carbone, caractérisé en ce qu'il consiste à transformer, selon une technique de craquage par étirage et rupture contrôlée des câbles de multifilaments de carbone, dont la teneur en carbone est supérieure à 95 %, dont le titre est compris entre 0,5 et 1 dtex, dont la résistance est comprise entre 2,2 et 3,3 GPa, dont le module d'Young est compris entre 230 et 335 GPa, et dont l'allongement à la rupture est compris entre 0,75 et 1,55 %, pour obtenir des fibres longues dont la longueur moyenne se situe entre 100 et 120 mm, puis à transformer ces fibres sur un matériel de filature classique pour fibres longues en une gamme de filés dont les titres sont compris entre Nm 1 et Nm 100.

2. Filé de fibres de carbone dont la longueur moyenne est comprise entre 100 et 120 mm, obtenu par la mise en oeuvre du procédé selon la revendication 1.

3. Application des filés de fibres de carbone selon la revendication 1 et la revendication 2 à la réalisation de tissus pré-imprégnés pour composites.

4. Application des filés de fibres de carbone selon la revendication 1 et la revendication 2 à la réalisation de tissus pour filtration sèche et humide.

5. Application des filés de fibres de carbone selon la revendication 1 et la revendication 2 à la réalisation de tissus pour confection de cages de Faraday.

6. Application des filés de fibres de carbone selon la revendication 1 et la revendication 2 à la réalisation de tissus destinés à la carbonisation pour pièce en carbone/carbone.

7. Application des filés de fibres de carbone selon la revendication 1 et la revendication 2 à la réalisation de garnitures d'étanchéité de haute performance.

**Claims**

1. A process for the manufacture of a yarn of carbon fibres, *characterized in that* it consists in transforming, by a technique of cracking by stretching and controlled fracture, cables of carbon multifilaments the content of carbon of which is greater than 95%, the count between 0.5 and 1 dtex, the strength between 2.2 and 3.3 gigapascals (GPa), the Young's modulus between 230 and 335 GPa, and the elongation at rupture between 0.75 and 1.55%, to obtain long fibres the average length of

3

EP 0 274 970 B1

which is between 100 and 120 mm, and then to transform these fibres on standard spinning equipment for long fibres into a range of yarns with counts between metric numbers Nm 1 and Nm 100.

2. A yarn of carbon fibres, the average length of which is between 100 and 120 mm, obtained by operation of the process according to Claim 1.

3. Application of yarns of carbon fibres according to Claim 1 and Claim 2 for the production of preimpregnated fabrics for composites.

4. Application of yarns of carbon fibres according to Claim 1 and Claim 2 for the production of fabrics for dry and damp filtration.

5. Application of yarns of carbon fibres according to Claim 1 and Claim 2 for the production of fabrics for the construction of Faraday cages.

6. Application of yarns of carbon fibres according to Claim 1 and Claim 2 for the production of fabrics intended for carbonization per piece into carbon/carbon.

7. Application of yarns of carbon fibres according to Claim 1 and Claim 2 for the production of high-performance impervious packings.

**Patentansprüche**

1. Verfahren zur Herstellung eines Garn aus Kohlenstoffasern, dadurch gekennzeichnet, daß man gemäß einem Spaltverfahren durch Strecken und kontrollierten Bruch Kabel aus Kohlenstoffmultifilamenten, deren Gehalt an Kohlenstoff größer als 95 % ist, deren Titer zwischen 0.5 und 1 dtex ist, deren Festigkeit zwischen 2.2 und 3.3 GPa liegt, deren Young-Modul zwischen 230 und 335 GPa liegt, und deren Bruchdehnung zwischen 0.75 und 1.55 % liegt, verarbeitet, um lange Fasern mit einer mittleren Länge zwischen 100 und 120 mm zu erhalten, und dann diese Fasern auf einer klassischen Spinnmaschine für lange Fasern zu einem Bereich von Garnen verarbeitet, deren Titer zwischen Nm 1 und Nm 100 liegen.

2. Garn aus Kohlenstoffasern mit einer mittleren Länge zwischen 100 und 120 mm, erhalten nach dem Verfahren gemäß Anspruch 1.

3. Verwendung der Garne aus Kohlenstoffasern gemäß Anspruch 1 und 2 zur Herstellung von preimprägnierten Geweben für Verbundkörper.

4. Verwendung von Garnen aus Kohlenstoffasern gemäß Anspruch 1 und 2 für Gewebe zur Trocken- und Naßfiltration.

5. Verwendung von Garnen aus Kohlenstoffasern gemäß Anspruch 1 und 2 für Gewebe zur Herstellung von Faraday'schen Käfigen.

6. Verwendung von Garnen aus Kohlenstoffasern gemäß Anspruch 1 und 2 für Gewebe, die zur Carbonisation für Teile aus Kohlenstoff/-Kohlenstoff bestimmt sind.

7. Verwendung von Garnen aus Kohlenstoffasern gemäß Anspruch 1 und 2 für Dichtungen hoher Leistung.

4